# EUROPEAN PATENT APPLICATION

(11) **EP 4 489 306 A1**
(43) Date of publication of application: **08.01.2025**
(21) Application number: 24181905.1
(22) Date of filing: 13.06.2024
(51) Int. Cl.: H03L 7/08, G01R 31/28

(54) **SYSTEM AND METHOD FOR TESTING CIRCUIT**

(30) Priority: 30.06.2023 US 202363511390 P; 10.10.2023 US 202318484245
(71) Applicant: STMicroelectronics International N.V., 1228 Plan-les-Ouates, Geneva (CH)
(72) Inventor: CASARSA, Marco, 20069 Vaprio d'Adda (Milano) (IT)
(74) Representative: Buzzi, Notaro & Antonielli d'Oulx S.p.A.

(57) **Abstract**

A system for testing a circuit includes a phase-locked loop (200), a test logic circuit (400, 500, 600, 700), and a test controller (300). The test logic circuit is coupled to the phase-locked loop. The test logic circuit (400, 500, 600, 700) is configured to count a number of clock cycles of the phase-locked loop (200) using a reference clock (414) as a reference. The reference clock (414) is coupled to the test logic circuit (400, 500, 600, 700). The test controller (300) is coupled to the phase-locked loop (200) and to the test logic circuit (400, 500, 600, 700). The test controller (300) is configured to measure a clock frequency of the phase-locked loop with the counted number of clock cycles received from the test logic circuit (400).

## Description

### Technical Field

The present disclosure relates generally to circuits and, in particular embodiments, to systems and method for testing circuits.

### Background

Phase-locked loops (PLLs) are control systems that generate output signals with respective phases that are related to the phases of respective input signals. Multiple types of PLLs exist, of which the simplest is an electronic circuit having a variable frequency oscillator and a phase detector coupled together in a feedback loop. An applied voltage proportionately controls the frequency and phase of the variable frequency oscillator. As such, the variable frequency oscillator is also referred to as a voltage-controlled oscillator (VCO). The oscillator produces a periodic signal with a specific frequency and the phase detector then compares the phase of the periodic signal with a respective phase of the input periodic signal. This allows for adjusting the oscillator to maintain phase matching between the input and output periodic signal.

Keeping the input and output phase in lockstep also implies keeping the input and output frequencies the same. Consequently, in addition to synchronizing signals, a phase-locked loop can track an input frequency, or it can generate a frequency that is a multiple of the input frequency. These properties are used for computer clock synchronization, demodulation, and frequency synthesis.

Phase-locked loops are widely employed in radio, telecommunications, computers, and other electronic applications, such as systems-on-a-chip for automotive applications. They can be used to demodulate a signal, recover a signal from a noisy communication channel, generate a stable frequency at multiples of an input frequency (frequency synthesis), or distribute precisely timed clock pulses in digital logic circuits such as microprocessors. Since a single integrated circuit can now provide a complete phase-locked loop building block, the technique is widely used in modem electronic devices, with output frequencies from a fraction of a hertz up to many gigahertz. As such, new solutions for testing phase-locked loops are desirable.

### Summary

The invention is defined by the appended claims. Specifically, according to one or more embodiments, the above objective is achieved by means of a system for testing a circuit and a related method. The claims are an integral part of the technical teaching of the disclosure provided herein.

In accordance with an embodiment, a system for testing a circuit includes: a phase-locked loop; a test logic circuit, the test logic circuit being coupled to the phase-locked loop, the test logic circuit being configured to count a number of clock cycles of the phase-locked loop using a reference clock as a reference, the reference clock being coupled to the test logic circuit; and a test controller, the test controller being coupled to the phase-locked loop and to the test logic circuit, the test controller being configured to measure a clock frequency of the phase-locked loop with the counted number of clock cycles received from the test logic circuit.

In accordance with another embodiment, a system for testing a circuit includes: a phase-locked loop; a test logic circuit, the test logic circuit being coupled to the phase-locked loop, the test logic circuit including: a lock cycles counter, the lock cycles counter being configured to count a number of cycles of a reference clock between an activation time of the phase-locked loop and a locked state time of the phase-locked loop, the reference clock being coupled to the test logic circuit; and a fast cycles counter, the fast cycles counter being configured to count a number of fast clock cycles of the phase-locked loop using the reference clock as a reference; and a test controller, the test controller being coupled to the phase-locked loop and to the test logic circuit, the test controller being configured to receive a lock cycles count signal from the lock cycles counter and a fast cycles count signal from the fast cycles counter.

In accordance with yet another embodiment, a method for testing a circuit includes: enabling a test logic circuit with a test controller, the test logic circuit being coupled to a phase-locked loop and to the test controller; counting a number of clock cycles of the phase-locked loop with the test logic circuit using a reference clock as a reference, the reference clock being coupled to the test logic circuit; and determining a clock frequency of the phase-locked loop with the test controller using the counted number of clock cycles.

It is to be understood that both the foregoing general description and the following detailed description are exemplary and explanatory only and are not restrictive of the disclosure, as claimed.

### Brief Description of the Drawings

For a more complete understanding of the present invention, and the advantages thereof, reference is now made to the following descriptions taken in conjunction with the accompanying drawings, in which:
- Figure 1 illustrates a schematic of a system for testing a phase-locked loop, in accordance with some embodiments;
- Figures 2-5 illustrate schematics of phase-locked loop test blocks, in accordance with some embodiments; and
- Figure 6 illustrates a flow chart of a method for testing a circuit, in accordance with some embodiments.

Corresponding numerals and symbols in the different figures generally refer to corresponding parts unless otherwise indicated. The figures are drawn to clearly illustrate the relevant aspects of the embodiments and are not necessarily drawn to scale. The edges of features drawn in the figures do not necessarily indicate the termination of the extent of the feature.

### Detailed Description of Illustrative Embodiments

The making and using of various embodiments are discussed in detail below. It should be appreciated, however, that the various embodiments described herein are applicable in a wide variety of specific contexts. The specific embodiments discussed are merely illustrative of specific ways to make and use various embodiments, and should not be construed in a limited scope.

The phrases "in one embodiment," "according to one embodiment," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

Phase-locked loops (PLLs) are widely used in semiconductor devices to increase external crystal oscillator frequency (which may be in the range of the MHz domain) relative to internal frequency (which may be in the range of the GHz domain). It is advantageous to test the performance of the PLL circuits during manufacturing in order to improve quality of completed devices (in other words, to avoid shipping of devices that are damaged or outside of specification). Due to the growing complexities of System-on-Chips (SoCs) and the consequent increase of the number of embedded PLLs, new testing architectures are desirable for PLL circuits.

According to one or more embodiments of the present disclosure, this application relates to electronic circuits for testing phase-locked loops (PLLs). Specific logic, also referred to as test blocks or test logic circuits, is added to monitor lock signals and the PLL clock frequency directly with the PLL output signals. This is advantageous as the signals do not need to be propagated through device input/output (IO) pads through alternate functions. This may decrease signal monitoring accuracy due to multiple signals being needed to be allocated on the same IO pads and an increase in distance (such as in a range of many millimeters) between the PLL and IO pads that may need pipeline stages. Additionally, signal monitoring on IO pads may not be accurate due to dividers and logic in between the PLLs and IO pads, which may decrease the accuracy of measuring parameters such as frequency.

The specific logic (in other words, the test blocks or test logic circuits) can be controlled and monitored with a test controller using a suitable standard interface such as IEEE 1149.1, IEEE 1500, or IEEE 1687 interface. As such, the classical IEEE standard interface pins are available on the test controllers as the boundary scan standard is usually required for meeting IEEE standards (such as IEEE 1149.x). Embodiments of the disclosure may provide advantages such as simplifying PLL test architecture, allowing for more accurate measurements of the PLL signals, reducing the test time for the PLLs and thereby allowing parallel execution of PLLs, standardizing PLL test architecture among different products, improving precision on frequency measurement (such as by adjusting reference capture windows), and simplifying the testing process on automatic test equipment (ATE) which may reduce complexity on boards or equipment and thereby allow for lower cost testing. Embodiments may allow for applying PLL testing during a burn-in phase of the board, such as by using a standard interface (e.g., Joint Test Action Group (JTAG) 1149.1). Embodiments also provide capability to run PLL testing in applications using advanced peripheral bus (APB) interface to monitor PLL frequency and wake-up time. Some embodiments include built-in self test (BIST) frequency capability.

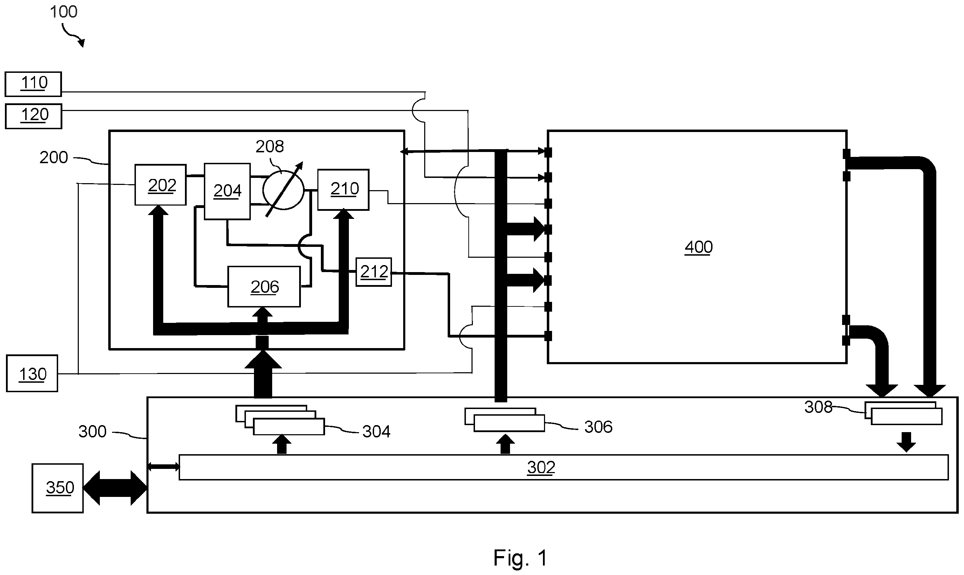

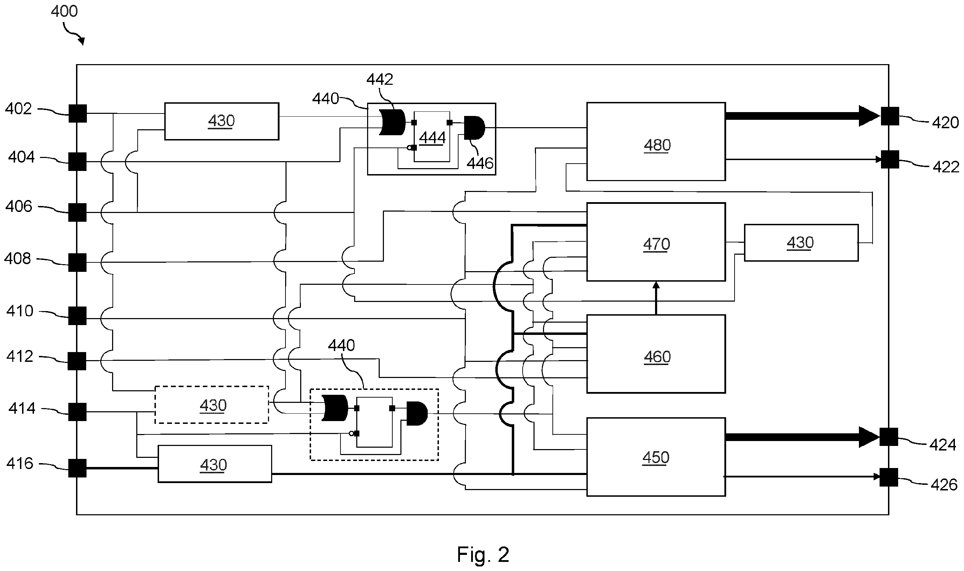

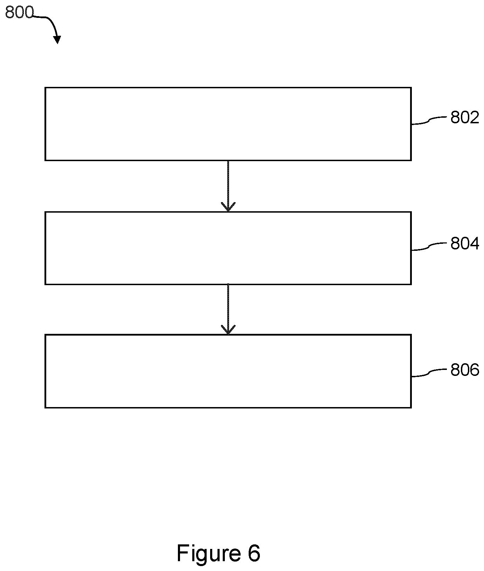

Embodiments of the disclosure are described in the context of the accompanying drawings. An embodiment of a system for testing one or more phase-locked loops will be described using Figure 1. Embodiments of test blocks for testing phase-locked loops will be described using Figures 2-5. An embodiment of a method for testing a circuit will be described using Figure 6.

Figure 1 illustrates a block diagram of a system 100 for testing a phase-locked loop 200. The system 100 includes the phase-locked loop 200 and may be part of a larger device, such as a System on Chip (SoC) or the like, which may be used for an automotive application. However, the system 100 may be included in any suitable device or system. A test controller 300 and a test block 400 are coupled to the phase-locked loop 200. Although one phase-locked loop 200 and one test block 400 are illustrated by Figure 1, any suitable number of phase-locked loops 200 may be coupled to and tested by the test controller 300 and any suitable number of test block 400s. In some embodiments, the system 100 comprises multiple phase-locked loops 200 and test blocks 400, and each phase-locked loop 200 is coupled to and tested by a respective test block 400. In other embodiments, multiple phase-locked loops 200 are coupled to and tested by a single test block 400, such as by multiplexing outputs of multiple phase-locked loops 200 that are located close to each other to single respective test blocks 400.

Phase-locked loop signals do not need to be routed through, for example, device IO pads because of the test block 400, as the signals are connected with the test controller 300. This may reduce or prevent a need for complex routing monitoring of signals on device IO pads. The one or more phase-locked loop(s) 200, the test controller 300, and the test block 400 may be part of a same electronic device, such as one or more semiconductor chips (or, in the case of chiplets, one or more semiconductor dies) which may be mounted on a circuit board.

The example phase-locked loop 200 comprises an input divider 202, a phase frequency detector (PFD) 204, a feedback divider 206, a voltage-controlled oscillator (VCO) 208, an output divider 210, and a lock circuit 212. The input divider 202 receives a reference signal from a reference clock 130. In some embodiments, the reference clock 130 is a precise and stable frequency source such as a crystal (e.g., quartz) oscillator that provides good precision and stability. The input divider 202, the feedback divider 206, and the output divider 210 may be coupled to the phase-locked loop control registers 304 of the test controller 300.

In the embodiment considered, the phase frequency detector 204 is coupled to the input divider 202 and the feedback divider 206. The phase frequency detector 204 generates a signal output that represents the difference in phase between the inputs from the input divider 202 and the feedback divider 206. This signal output is coupled to the voltage-controlled oscillator 208 in order to control the oscillation frequency of the voltage-controlled oscillator 208. An output of the voltage-controller oscillator 208 is coupled to the feedback divider 206 to provide stability to the voltage-controlled oscillator 208 along a feedback loop. The output of the voltage-controller oscillator 208 is further coupled to an output divider 210 to reduce the output frequency of the signal from the voltage-controller oscillator 208. In the embodiment considered, the output from the output divider 210 is coupled to the test block 400 to provide a fast clock signal to be evaluated by the test block 400. In various embodiments, the output from the output divider 210 is not coupled only with the test block 400, as it is also coupled with the functional logic that receives the fast clock signal from the phase-locked loop 200 in order to work functionally. In the embodiments considered, the lock circuit 212 is coupled to output from the phase frequency detector 204 to determine if the phase-locked loop 200 is in a locked state. An output signal from the lock circuit 212 indicating that the phase-locked loop 200 is in a locked state is coupled to the test block 400. The output from the lock circuit 212 may be further coupled to any suitable input (e.g., an input of a functional logic) to provide a signal indicating if the phase-locked loop 200 is in a locked state or not.

The phase-locked loop 200 is included as a non-limiting example, and the test architecture (including the test block 400) may be used to test any suitable phase-locked loop circuits. As such, any and all such combinations of phase-locked loops with the test architecture are within the scope of the disclosed embodiments.

The test controller 300 may be controlled using a suitable standard interface such as IEEE 1149.1, IEEE 1500, or IEEE 1687 (for example, during a manufacturing test). In some embodiments, the test controller 300 is controlled using an advanced peripheral bus (APB) interface through a bridge 350 (e.g., an APB to IEEE bridge). This may be advantageous by letting the test block 400 to be run during runtime of an application (e.g., an automotive application or other application being run the device including the system 100 after the completion of manufacturing) and allows for the monitoring of phase-locked loop lock time and phase-locked loop frequency. The application can monitor phase-locked loop lock time when the phase-locked loop is woken up and monitor phase-locked loop lock frequency at any time during the lifetime of the application. This may be useful to measure frequency drift in the application over time (such as at different temperatures or at different points across the device history timeline to check for aging effects). This may be a crucial feature particularly for safety applications (for example, safety functions of automotive applications). The test controller 300 allows for testing multiple phase-locked loops nearly in parallel (in other words, parameters are loaded into phase-locked loops serially and testing of the phase-locked loops is performed in parallel), which may save testing time during manufacturing. As such, the system 100 including one or more phase-locked loop(s) 200, the test controller 300, and one or more test blocks 400 allows for the testing of functional requirements of the phase-locked loop(s) 200 together with the testing of manufacturing requirements of the phase-locked loop(s) 200. This may increase the testing performance with respect to testing functional and manufacturing requirements.

In various embodiments, the test controller 300 comprises a control circuit 302, phase-locked loop control registers 304, test block control registers 306, and test block status registers 308. In some embodiments, the control circuit 302 comprises a finite state machine using an IEEE standard, control logic, the like, or a combination thereof. However, any suitable control circuit 302 may be used. The control circuit 302 may control components of the phase-locked loop 200 (e.g., the input divider 202, the feedback divider 206 and the output divider 210) and may control the test block 400 through the test block control registers 306. The control circuit 302 further receives output from the test block 400 (e.g., data on the number of clock cycles counted by the test block 400) through the test block status registers 308.

In the embodiment considered, the test block 400 (also referred to as a test logic circuit) is used to test the one or more phase-locked loop(s) 200 by, for example, measuring the frequencies of fast clock signals from the phase-locked loop(s) 200. The test block 400 receives input from the phase-locked loop 200 (e.g., a fast clock signal from the output divider 210 and a locked state signal from the lock circuit 212) and from test block control registers 306 of the test controller 300 (e.g., a test enable signal, a reference clock cycle signal, and a delay signal).

In various embodiments, the test block 400 further receives a clock gate cell enabling signal from a clock gate controlling circuit 110 and an asynchronous reset signal from a reset-providing circuit 120. The clock gate controlling circuit 110 is any suitable circuit that may provide a clock gate cell enabling signal, and the reset-providing circuit 120 is any suitable circuit that may provide a reset-providing signal. In some embodiments, the clock gate enabling signal and/or the asynchronous reset signal are provided from the test controller 300 or an APB interface coupled with the test controller 300. However, any suitable circuits may be used to provide a clock gate cell enabling signal and an asynchronous reset signal to the test block 400.

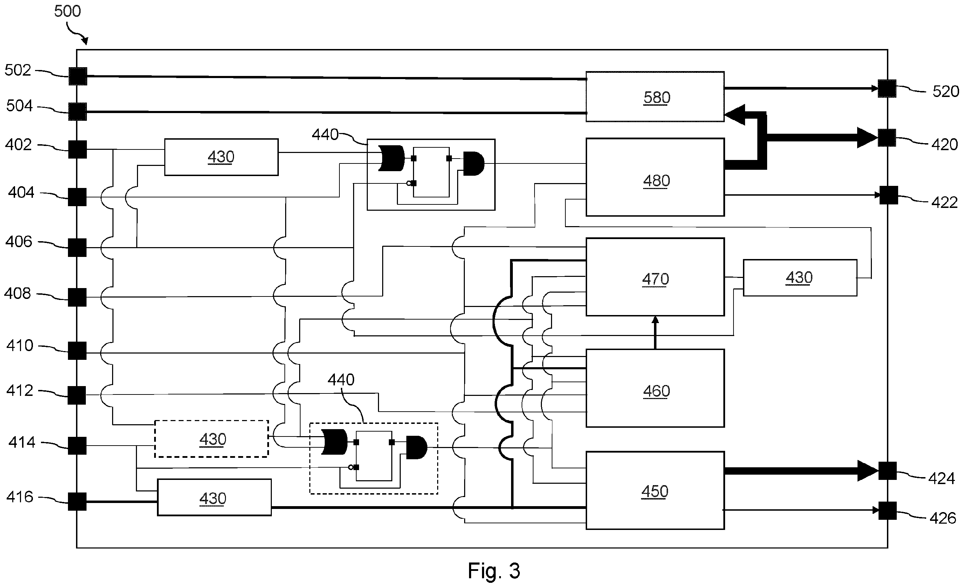

An embodiment of the test block 400 is described in greater detail below with respect to Figure 2. Although Figure 1 illustrates the system 100 including the test block 400, the system 100 may also include the test block 500, 600, or 700 as described below with respect to Figures 3, 4, and 5, respectively, and any and all such combinations are within the scope of the disclosed embodiments.

Figure 2 illustrates a block diagram of the test block 400 for testing a phase-locked loop, in accordance with some embodiments. The test block 400 is coupled with the phase-locked loop (e.g., the phase-locked loop 200; see above, Figure 1) and a test controller (e.g., the test controller 300; see above, Figure 1). The test block 400 (also referred to as specific logic) is used to monitor lock signals and the phase-locked loop clock frequency directly with the phase-locked loop output signals. This is advantageous as the phase-locked loop signals do not need to be propagated through other circuitry (e.g., device IO PADs). The test block 400 includes input terminals 402, 404, 406, 408, 410, 412, 414, and 416, output terminals 420, 422, 424, and 426, synchronizers 430, one or more clock gating cell(s) 440, a lock cycles counter 450, a delay reference counter 460, a reference cycles counter 470, and a fast cycles counter 480. The lock cycles counter 450, the delay reference counter 460, the reference cycles counter 470, and the fast cycles counter 480 are circuits comprising suitable logic gates (combinational, sequential, or a combination thereof), other circuit components, the like, or a combination thereof.

In the various embodiments, input terminal 402 receives a signal (also referred to as a test enable signal) that enables the test block 400. The test enable signal may be provided from the test block control registers 306 of the test controller 300. The input terminal 402 is coupled to the fast cycles counter 480 through a first synchronizer 430 and a first clock gating cell 440. When the signal received at the input terminal 402 is 0, the test block 400 is off. The test block 400 begins operating when the signal received at the input terminal 402 transitions from 0 to 1, and the test block 400 stops operating when the signal received at the input terminal 402 transitions from 1 to 0.

In the various embodiments, input terminal 404 receives a signal (also referred to as a test gated clock signal) that is coupled to respective inputs of the one or more clock gating cell(s) 440. The test gated clock signal may be provided by, for example, a clock gate controlling circuit 110 (see above, Figure 1). The test gated clock signal is the enabling signal of the one or more clock gating cell(s) 440. The test gated clock signal may be used to cover defects related to the clock gating cell(s) 440 during automatic test pattern generation (ATPG) steps, which is advantageous as many current devices comprise scan architecture. In various embodiments, clock gating cells (e.g., the clock gating cell(s) 440) have a test enable (TE) pin (such as the lower input of the OR gate 442) that is at a high voltage when an automatic test pattern generation is run (such as shifting into a scan chain) to prevent shift issues in the scan chains. The test pin may be left at a low value (e.g., 0 in comparison with the 1 while the automatic test pattern generation is run) in capture cycles to increase coverage on the upper input of the OR gate 442, which may be coupled with an output of a synchronizer 430.

In the various embodiments, input terminal 406 receives a clock signal (also referred to as a fast clock signal) from the output divider 210 of the phase-locked loop 200 (see above, Figure 1). The fast clock signal is one of the inputs from the phase-locked loop 200 that will be monitored and tested by the test block 400.

Input terminal 408 receives a reference clock desired cycles signal from a bus coupled to test block control registers 306 of the test controller 300. The reference clock desired cycles signal provides the number of reference clock cycles for the test block 400 to use in order to capture the number of clock cycles of the fast clock signal. In some embodiments, the desired number of reference clock cycles is in a range of 256 cycles to 65536 cycles.

Input terminal 410 provides an asynchronous reset signal for flip-flops included in the test block 400, such as flip-flops in the lock cycles counter 450, the delay reference counter 460, the reference cycles counter 470, and the fast cycles counter 480. The asynchronous reset signal may be provided by, for example, a reset-providing circuit 120 (see above, Figure 1). The asynchronous reset signal enables the resetting of sequential elements in, for example, the lock cycles counter 450, the delay reference counter 460, the reference cycles counter 470, and the fast cycles counter 480.

In the various embodiments, input terminal 412 provides a delay time (measured in terms of reference clock cycles) between the toggling of the test enable signal from 0 to 1 to enable the test block 400 and a start of counting of fast clock cycles. The delay signal (also referred to as a clock delay signal) may be provided from a bus coupled to test block control registers 306 of the test controller 300. This may be advantageous because, when a phase-locked loop 200 is enabled, it may not be in a stable condition, such as to achieve a resolution on the order of parts per million (ppm) and/or lower jitter. As such, a certain amount of delay time (provided by the delay signal through input terminal 412) may be useful in order to have a stable and reliable measure from the fast clock of the phase-locked loop 200.

In the various embodiments, input terminal 414 provides a reference clock signal used as a time reference for counting the fast clock cycles of the phase-locked loop 200. The reference clock signal may be provided from the reference clock 130 (see above, Figure 1).

In the various embodiments, input terminal 416 provides a locked signal that indicates that the phase-locked loop 200 is in a locked condition so that the fast clock signal produced by the phase-locked loop 200 (and delivered to input terminal 406) is set at the desired frequency. This may be useful as a measurement of a time between when the phase-locked loop 200 is set or enabled and when the phase-locked loop 200 is locked may be a phase-locked loop specification requirement that is desirable to check. The locked signal may be provided from the lock circuit 212 of the phase-locked loop 200 (see above, Figure 1).

In the embodiment considered, a first synchronizer 430 receives the test enable signal from the input terminal 402 and the fast clock signal from the input terminal 406. In some embodiments, the synchronizers 430 are circuits built with multiple pipeline flip-flop stages (e.g., two to three pipeline flip-flop stages). However, any suitable synchronizing circuit may be used for the first synchronizer 430. The synchronizers 430 may be used in the test block 400 to reduce or prevent metastability issues, such as when a clock signal is asynchronous with respect to a data signal. For example, the test enable signal may be asynchronous with respect to the fast clock signal, so the first synchronizer 430 is advantageous for reducing or preventing metastability issues.

In the embodiment considered, a second synchronizer 430 receives the reference clock signal from the input terminal 414 and the locked signal from the input terminal 416. The second synchronizer 430 may be advantageous for reducing or preventing metastability issues that may occur when the locked signal is asynchronous with respect to the reference clock signal. The second synchronizer 430 may be substantially similar to the first synchronizer 430 as described above, and the details are not repeated herein. However, any suitable synchronizing circuit may be used for the second synchronizer 430.

In the embodiment considered, a first clock gating cell 440 receives synchronized input from the first synchronizer 430, the test gated clock signal from input terminal 404, and the fast clock signal from input terminal 406. Clock gating cells such as the first clock gating cell 440 are used to gate the fast clock and save power when the logic of the test block 400 is off (in other words, when the test enable signal is set to zero). In the illustrated example of Figure 2, the first clock gating cycle 440 includes an OR gate 442, a latch 444, and an AND gate 446. The OR gate 442 receives the synchronized input from the first synchronizer 430 of the test enable signal and the fast clock signal and the test gated clock signal. The latch 444 receives as input the output of the OR gate 442 and the fast clock signal through an inverter. The AND gate 446 receives as input the fast clock signal and the output of the latch 444. The output of the AND gate 446, which is the output of the first clock gating cell 440, is a gated fast clock signal that is coupled to an input of the fast cycles counter 480. However, the first clock gating cell 440 may have any suitable structure and components.

In some embodiments, a third synchronizer 430 receives the test enable signal from the input terminal 402 and the reference clock signal from the input terminal 414. The third synchronizer 430 may be advantageous for reducing or preventing metastability issues that may occur when the test enable signal is asynchronous with respect to the reference clock signal. The third synchronizer 430 may be substantially similar to the first synchronizer 430 as described above, and the details are not repeated herein. However, any suitable synchronizing circuit may be used for the third synchronizer 430. The third synchronizer 430 is illustrated with a dashed line as it is optional depending on whether the test enable signal and the reference clock signal are synchronous.

In some embodiments, a second clock gating cell 440 receives synchronized input from the third synchronizer 430, the test gated clock signal from input terminal 404, and the reference clock signal from input terminal 414 The second clock gating cell 440 may be similar to the first clock gating cell 440 as described above with a substitution of the reference clock signal for the fast clock signal, and the details are not repeated herein. However, any suitable clock gating cell may be used for the second clock gating cell 440. The second clock gating cell 440 is also illustrated with a dashed link as it can be optional because, for example, in some cases the clock gating cell may be placed outside of the test block 400 so that the reference clock signal is tied off at a higher level in the hierarchy of the larger device. This may be advantageous for saving power when the test block 400 is not active, as it may avoid having the second clock gating cell 440 being active even when the test block 400 is not in use In these cases, the reference clock signal is propagated to the test block 400 only when it is needed (in other words, when the test block 400 is active), and the second clock gating cell 440 may not be needed.

In the embodiment considered, the lock cycles counter 450 measures the activation to locked state time of the phase-locked loop 200. The lock cycles counter 450 receives as input the reference clock signal (which may be gated by the second clock gating cell 440, if present), the locked signal from the second synchronizer 430 (synchronized with the reference clock signal), the test enable signal (which may be synchronized with the reference clock signal by the third synchronizer 430, if present), and the asynchronous reset signal from the input terminal 410. The lock cycles counter 450 uses the reference clock signal (with or without synchronization and/or clock gating) and is enabled when the test enable signal (with or without synchronization with the reference clock signal) goes from 0 to 1. This starts a counting of the lock cycles of the phase-locked loop 200 using the reference clock signal as a reference until the locked signal (with synchronization with the reference clock signal) also goes from 0 to 1.

In the embodiment considered, the lock cycles counter 450 provides a lock cycles count signal as output to the output terminal 424, which is the number of lock cycles measured between the assertion of the test enable signal and the time when the locked signal reaches its high value (e.g., 1). The lock cycles count signal can be multiplied with the period of the reference clock to provide the lock time of the phase-locked loop 200 (in other words, the time it takes the phase-locked loop 200 to reach a locked state from its activation). This lock time may be used to check if the phase-locked loop 200 is performing according to its specification. The lock cycles counter 450 also provides a lock count end signal as output to the output terminal 426, which goes to 1 when counting is over (in other words, when the lock cycles signal is at 1). This can be used to validate that the lock cycles count signal is reliable. The output terminals 424 and 426 are coupled to the test controller 300 through the test block status registers 308 to provide the lock cycles count signal and the lock count end signal, respectively, to the test controller 300.

In the embodiment considered, the delay reference counter 460 delays the initial counting of the fast clock signal from the phase-locked loop 200 and the counting of the reference cycles counter 470 for a certain time after the startup of the phase-locked loop 200 when the phase-locked loop 200 is not in a stable condition, such as to achieve a resolution on the order of parts per million (ppm) and/or lower jitter. The delay reference counter 460 receives as input the delay signal from the input terminal 412, the reference clock signal (which may be gated by the second clock gating cell 440, if present), the locked signal from the second synchronizer 430 (synchronized with the reference clock signal), the test enable signal (which may be synchronized with the reference clock signal by the third synchronizer 430, if present), and the asynchronous reset signal from the input terminal 410. The delay reference counter uses the reference clock signal (with or without synchronization and clock gating) as a reference and begins counting when the test enable signal (with or without synchronization) goes from 0 to 1 and the locked signal (after synchronization with the reference clock signal) reaches a high value of 1. The delay reference counter 460 circuit then counts a number of cycles of the reference clock provided by the delay signal before enabling the reference cycles counter 470 by sending an enabling signal (such as a signal with a value of 1).

In the embodiment considered, the reference cycles counter 470 provides an output that sets a window over which the fast cycles counter 480 performs its counting. The reference cycles counter 470 receives as input the reference clock desired cycles signal from the input terminal 408, the reference clock signal (which may be gated by the second clock gating cell 440, if present), the locked signal from the second synchronizer 430 (synchronized with the reference clock signal), the test enable signal (which may be synchronized with the reference clock signal by the third synchronizer 430, if present), an enabling signal from the delay reference counter 460, and the asynchronous reset signal from the input terminal 410. The reference cycles counter 470 is enabled when it receives the enabling signal of 1 from the delay reference counter 460 and when the locked signal and the test enable signal (with or without synchronization) are also 1. The reference cycles counter 470 then begins counting the reference clock cycles from the reference clock signal (with or without synchronization and clock gating) as a reference. The output of the reference cycles counter 470 is coupled through a fourth synchronizer 430 to the fast cycles counter 480.

In the embodiment considered, the fourth synchronizer 430 receives the counted reference clock cycle signal from the reference cycles counter 470 and the fast clock signal from the input terminal 406. The counted reference clock cycle signal from the reference cycles counter 470 becomes active when the reference cycles counter 470 begins counting. The counted reference clock cycle signal from the reference cycles counter 470 remains active until as the reference counter 470 reaches the end of its counting as given by the value of the reference clock desired cycles signal from the input terminal 408. The fourth synchronizer 430 may be advantageous for synchronizing the counted reference clock cycle signal with the fast clock signal in order to set the window over which the fast cycles counter 480 performs its counting. The fourth synchronizer 430 may be substantially similar to the first synchronizer 430 as described above, and the details are not repeated herein. However, any suitable synchronizing circuit may be used for the fourth synchronizer 430. In some embodiments, the counted reference clock cycle signal is synchronized with the fast clock signal by using output from the first clock gating cell 440 rather than the clock of the fourth synchronizer 430.

In the embodiment considered, the fast cycles counter 480 counts fast clock cycles from the phase-locked loop 200 to measure the performance of the phase-locked loop 200. The fast cycles counter 480 receives as input the gated fast clock signal from the first clock gating cell 440, the counted reference clock cycle signal from the reference cycles counter 470 (synchronized with the fast clock signal through the fourth synchronizer 430), and the asynchronous reset signal from the input terminal 410. The fast cycles counter 480 receives the fast clock signal (after synchronization and clock gating) and counts cycles of the fast clock signal when the counted reference clock cycle signal is in the window set by the reference clock desired cycles signal, in addition to the other constraints on the start-up of the reference cycles counter 470 described above with respect to the reference cycles counter 470 (e.g., the potential delay from the delay reference counter 460).

In the embodiment considered, the counted number of cycles of the fast clock signal is provided as a fast cycles count signal to the output terminal 420. The fast cycles count signal provides the number of fast clock cycles counted in the desired number of reference clock cycles (with the desired number originally provided by the reference clock desired cycles signal through input terminal 408). This value provides the ratio between the rate of the fast clock of the phase-locked loop 200 and the reference clock, which is used (e.g., by the test controller 300) to determine the frequency of the fast clock. The fast cycles counter 480 flags the counting as complete with a fast complete signal, which validates the value of the fast cycles count signal when the fast complete signal is set to 1. The fast cycles counter 480 provides the fast complete signal as output to the output terminal 422. The fast complete signal is used (e.g., by the test controller 300) to check when the counting of the fast clock cycles by the fast cycles counter 480 is over, thereby indicating that the fast cycles count signal is reliable. The output terminals 420 and 422 are coupled to the test controller 300 through the test block status registers 308 to provide the fast cycles count signal and the fast complete signal, respectively, to the test controller 300.

The positions and couplings of the synchronizers 430 and the one or more clock gating cell(s) 440 with respect to the other components of the test block 400 are included as a non-limiting example. Any suitable positions and couplings of the synchronizers 430 and the one or more clock gating cell(s) 440 with respect to the other components of the test block 400 are within the scope of the disclosed embodiments.

Figure 3 illustrates a block diagram of a test block 500 (also referred to as a test logic circuit) for testing a phase-locked loop, in accordance with some embodiments. The test block 500 is similar to the test block 400 as described above with respect to Figure 2 with the addition of input terminals 502 and 504, a fast cycles comparator 580, and an output terminal 520. The test block 500 provides functionality to evaluate if the frequency of the fast clock is in a desired range.

In various embodiments, input terminal 502 receives an expected fast cycles signal from an output bus. The expected fast cycles signal is the expected number of fast clock cycles counted by the fast cycles counter 480 (in other words, the expected number of the fast cycles count signal; see above, Figure 2). In some embodiments, the expected number of fast clock cycles is in a range of 1,000 cycles to 16,000 cycles. In some embodiments, the output bus is coupled to test block control registers 306 of the test controller 300, and the test controller 300 provides the expected number of fast cycles. However, the output bus may be coupled to any suitable circuit to supply the expected fast cycles signal to the input terminal 502.

In various embodiments, input terminal 504 receives a fast cycle range signal from an output bus. The fast cycle range signal is a tolerance set between the expected fast cycles signal and the obtained number of the fast cycles count signal. In some embodiments, the output bus is coupled to test block control registers 306 of the test controller 300, and the test controller 300 provides the fast cycle range. However, the output bus may be coupled to any suitable circuit to supply the fast cycle range to the input terminal 504. In some embodiments, the value of the fast cycle range is in a range of 2 to 16.

In the embodiment considered, the fast cycles comparator 580 performs a comparison between the measured number of fast cycles and the expected number of fast cycles. The fast cycles comparator 580 may be a combinatorial logic circuit or a circuit using sequential logic. However, any suitable circuit may be used for the fast cycles comparator 580. The fast cycles comparator 580 receives as input the expected fast cycles signal from input terminal 502, the fast cycle range signal from input terminal 504, and the fast cycles count signal from the fast cycles counter 480.

In some embodiments, the fast cycles comparator 580 evaluates the fast cycle range as the number of cycles by which the fast cycles count signal may be either above or below the expected fast cycles signal. In other words, the fast cycles comparator 580 performs a comparison between the measured value of fast cycles from the fast cycles counter 480 and the desired range of expected values of the fast cycles. The desired range is the expected number of fast cycles minus the fast cycle range to the expected number of fast cycles plus the fast cycle range, or in other words the desired range extends above and below the expected number of fast clock cycles by a fast cycle range. This may set a range of valid values of counted fast cycles. This tolerance is advantageous because the number of counted fast cycles for a desired number of reference clock cycles may not be a constant value and may vary to a degree. This may be due to factors such as the fast clock of the phase-locked loop 200 and the reference clock being asynchronous and possible jitter of the fast clock (related to operation of the phase-locked loop 200). As such, it is desirable to monitor a narrow window of value around the expected value of fast cycles rather than a precise number of fast cycles.

In the embodiment considered, the fast cycles comparator 580 provides a fast status signal as output to the output terminal 520, which is coupled to the test controller 300 through the test block status registers 308 to provide the fast status signal to the test controller 300. The fast status signal flags whether the measured value of fast cycles is in the desired range of expected values of the fast cycles. For example, the fast status signal may be 1 when the measured value of fast cycles is inside the desired range and 0 when the measured value of fast cycles is outside the desired range. The value of the fast status signal will be valid when the fast complete signal (see above, Figure 2) is set to 1.

In the embodiment considered, the test block 500 allows for setting the expected value of fast cycles and setting a desired range to check whether the frequency of the fast clock of the phase-locked loop 200 is within the desired range. Adjusting the desired range of expected values of the fast cycles allows for checking frequency of the fast clock and checking the frequency deviation or modulation of the fast clock against the desired frequency by performing multiple measurements over a range of time (in other words, sampling the fast cycles count in different slices of time), which may be useful for identifying frequency deviation or modulation. This may be performed during manufacturing of the device and also during operation of the completed device as part of an application (e.g., an automotive application), such as with a specific structure (e.g., an APB bridge) also used in the application.

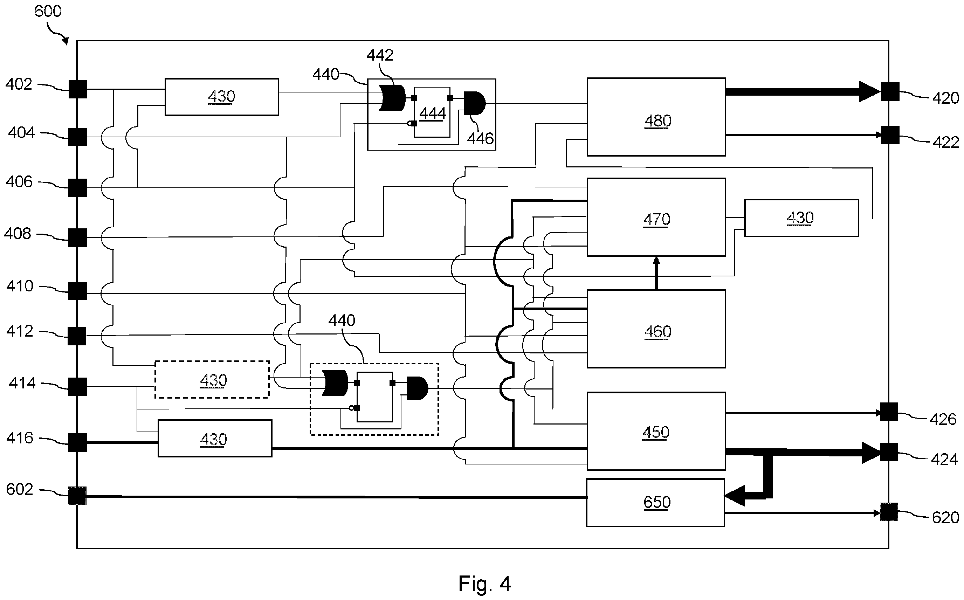

Figure 4 illustrates a block diagram of a test block 600 (also referred to as a test logic circuit) for testing a phase-locked loop, in accordance with some embodiments. The test block 600 is similar to the test block 400 as described above with respect to Figure 2 with the addition of input terminal 602, a lock comparator 650, and an output terminal 620. The test block 600 provides functionality to evaluate if the lock cycles count from the lock cycles counter 450 (see above, Figure 2) is below the expected maximum lock cycles provided from input terminal 602.

In various embodiments, input terminal 602 receives an expected maximum lock cycles signal from an output bus. The expected maximum lock cycles signal is the maximum expected number of lock cycles counted by the lock cycles counter 450 (in other words, the expected number of reference clock cycles from the activation of the phase-locked loop 200 until it reaches a locked state; see above, Figure 2). In some embodiments, the output bus is coupled to test block control registers 306 of the test controller 300, and the test controller 300 provides the expected maximum number of lock cycles. However, the output bus may be coupled to any suitable circuit to supply the expected maximum lock cycles signal to the input terminal 602.

In the embodiment considered, the lock comparator 650 performs a comparison between the measured number of lock cycles from the lock cycles counter 450 and the expected maximum number of lock cycles. In some embodiments, the lock comparator 650 is a combinatorial logic circuit or a circuit using sequential logic. In embodiments where the lock comparator 650 is a circuit using sequential logic, the lock comparator 650 receives a suitable clock signal as input from a suitable clock circuit. However, any suitable circuit may be used for the lock comparator 650. The lock comparator 650 receives as input of the expected maximum lock cycles signal from input terminal 602 and the lock cycles count signal from the lock cycles counter 450.

In the embodiment considered, the lock comparator 650 provides a lock status signal as output to the output terminal 620, which is coupled to the test controller 300 through the test block status registers 308 to provide the lock status signal to the test controller 300. The lock status signal is a single signal that flags whether the measured number of lock cycles is not exceeding the expected maximum number of lock cycles. If the measured number of lock cycles does exceed the expected maximum number of lock cycles, the phase-locked loop 200 lock time may be outside of a desired range of its specification. This may indicate that the phase-locked loop 200 may have internal damage. In this case, the lock status signal will stay at 0 to flag that the phase-locked loop 200 lock time is outside of the desired range. If the measured number of lock cycles does not exceed the expected maximum number of lock cycles, the phase-locked loop 200 lock time is inside the desired range. In this case, the lock status signal will stay at 1 to flag that the phase-locked loop 200 lock time is inside of the desired range. The value of the lock status signal will be valid when the lock count end signal (see above, Figure 2) is set to 1.

In some embodiments of the system 100 with the test block 600, the fast clock signal from input terminal 406 and the locked signal from input terminal 416 (see above, Figure 2) are both checked when the test enable signal from input terminal 402 enables the test block 600. In other embodiments, the checking of the fast clock signal and the locked signal are separated so that only the frequency of the fast clock signal is monitored during runtime of an application and the locked signal is monitored only during wake-up of the test block 600.

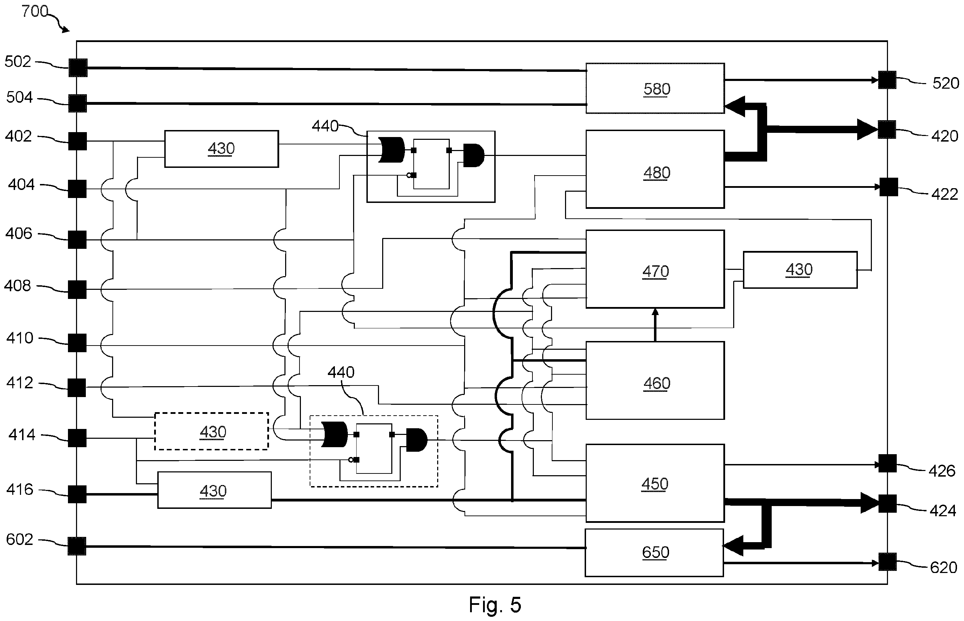

Figure 5 illustrates a block diagram of a test block 700 (also referred to as a test logic circuit) for testing a phase-locked loop, in accordance with some embodiments. The test block 500 is similar to the test block 400 as described above with respect to Figure 2, with the addition of input terminals 502 and 504, a fast cycles comparator 580, and an output terminal 520 as in the test block 500 (see above, Figure 3), and with the addition of input terminal 602, a lock comparator 650, and an output terminal 620 as in the test block 600 (see above, Figure 4). In other words, the embodiment of the test block 700 combine the embodiments of the test blocks 500 and 600 as described above with respect to Figures 3 and 4, respectively, and the details are not repeated herein. The test block 700 provides functionality to evaluate if the frequency of the fast clock is in a desired range and if the lock cycles count from the lock cycles counter 450 (see above, Figure 2) is below a desired value.

Embodiments of the test blocks 500, 600, and 700 as described above with respect to Figures 3, 4, and 5, respectively, allow for increasing the capability of built-in self tests (BIST) run by the test controller 300 (see above, Figure 1) because the test controller 300 can monitor the fast status signal and/or the lock status signal rather than monitoring the expected counter values for both the fast cycles count signal and the lock cycles count signal. This may increase the efficiency of communication for built-in self tests by reducing the amount of used bandwidth.

In some embodiments (such as embodiments of the test blocks 500, 600, and 700) an interrupt signal may be added when the check of the phase-locked loop 200 by the respective test block is over so that pass/fail flags can be checked (e.g., through an APB interface coupled with the test controller 300) without using a polling mechanism. In some embodiments, at power-on of the device the APB is set to configure the expected and control registers of the test controller 300. During subsequent runtime, the test controller 300 may directly control the start signal (e.g., the test enable signal) and monitor the fast cycles count signal and the fast complete signal for the phase-locked loop 200 fast clock and the lock cycles count signal and the lock count end signal for the phase-locked loop 200 lock time. This is advantageous as it reduces the need to read or write to the test controller 300 through the APB during application runtime because the interrupt signal allows the data to be read when operation is over without polling register content. The interrupt signal may also be generated when the fast cycles count signal is over in situations other than when the phase-locked loop 200 is locked.

Although Figure 1 above illustrates the system 100 as including the test block 400 (described above with respect to Figure 2), in some embodiments the system 100 includes the test block 500 (described above with respect to Figure 3), the test block 600 (described above with respect to Figure 4), or the test block 700 (described above with respect to Figure 5) in place of the test block 400. Additionally, in some embodiments the system 100 comprises multiple phase-locked loops with each phase-locked loop coupled to a respective test block. Each respective test block may be any of the test blocks 400, 500, 600, or 700, and any and all such combinations are within the scope of the disclosed embodiments. For example, a system may include multiple phase-locked loops 200 coupled with one test block 400, 500, 600, or 700 and one test controller 300. In this example, the test controller 300 has a register that allows for selecting the input terminal 406 receiving the fast clock signal(s) and the input terminal 416 receiving the locked signal(s) from selected phase-locked loops 200. The appropriate phase-locked loop control registers 304 and test block status registers 308 may be programmed or checked depending on the phase-locked loops 200 being tested. This may be advantageous for saving silicon area.

Figure 6 illustrates a flow chart of a method 800 for testing a circuit, in accordance with some embodiments. In step 802, a test logic circuit (e.g., a test block 400) is enabled with a test controller 300, as described above with respect to Figures 1 and 2. The test logic circuit is coupled to a phase-locked loop 200 and to the test controller 300.

In step 804, the test logic circuit counts a number of clock cycles of the phase-locked loop 200 using a reference clock 130 as a reference, as described above with respect to Figure 2. The reference clock 130 is coupled to the test block 400.

In step 806, the test controller 300 determines a clock frequency of the phase-locked loop 200 using the counted number of clock cycles, as described above with respect to Figure 2.

Example embodiments of the disclosure are summarized here. Other embodiments can also be understood from the entirety of the specification as well as the claims filed herein.

Example 1. A system for testing a circuit, the system including: a phase-locked loop; a test logic circuit, the test logic circuit being coupled to the phase-locked loop, the test logic circuit being configured to count a number of clock cycles of the phase-locked loop using a reference clock as a reference, the reference clock being coupled to the test logic circuit; and a test controller, the test controller being coupled to the phase-locked loop and to the test logic circuit, the test controller being configured to measure a clock frequency of the phase-locked loop with the counted number of clock cycles received from the test logic circuit.

Example 2. The system of example 1, where the test logic circuit is further configured to count a number of cycles of the reference clock between an activation time of the phase-locked loop and a locked state time of the phase-locked loop.

Example 3. The system of example 2, where the test logic circuit is further configured to provide a lock status signal to the test controller based on the counted number of cycles of the reference clock between the activation time of the phase-locked loop and the locked state time of the phase-locked loop.

Example 4. The system of one of examples 2 or 3, where the test logic circuit includes a reference cycles counter, the reference cycles counter being configured to set a window over which the number of clock cycles of the phase-locked loop are counted.

Example 5. The system of example 4, where the test logic circuit further includes a delay reference counter, the delay reference counter being configured to enable the reference cycles counter after a delay time.

Example 6. The system of one of examples 1 to 5, where the test logic circuit includes a clock gating cell, the clock gating cell being configured to gate a clock signal from the phase-locked loop.

Example 7. The system of one of examples 1 to 6, where the test controller is controlled using an advanced peripheral bus interface, the advanced peripheral bus interface being coupled to the test controller through a bridge.

Example 8. The system of one of examples 1 to 7, where the test controller is further configured to use an IEEE 1149.1, IEEE 1149.x, IEEE 1500, or IEEE 1687 interface.

Example 9. The system of one of examples 1 to 8, where the test controller is further configured to run a built-in self test.

Example 10. A system for testing a circuit, the system including: a phase-locked loop; a test logic circuit, the test logic circuit being coupled to the phase-locked loop, the test logic circuit including: a lock cycles counter, the lock cycles counter being configured to count a number of cycles of a reference clock between an activation time of the phase-locked loop and a locked state time of the phase-locked loop, the reference clock being coupled to the test logic circuit; and a fast cycles counter, the fast cycles counter being configured to count a number of fast clock cycles of the phase-locked loop using the reference clock as a reference; and a test controller, the test controller being coupled to the phase-locked loop and to the test logic circuit, the test controller being configured to receive a lock cycles count signal from the lock cycles counter and a fast cycles count signal from the fast cycles counter.

Example 11. The system of example 10, where the lock cycles counter is further configured to provide a lock status signal to the test controller.

Example 12. The system of one of examples 10 or 11, where the fast cycles counter is further configured to provide a fast status signal to the test controller.

Example 13. The system of one of examples 10 to 12, where the test logic circuit further includes a lock comparator, the lock comparator being configured to perform a comparison between a measured number of lock cycles from the lock cycles counter and an expected maximum number of lock cycles.

Example 14. The system of example 13, where the expected maximum number of lock cycles is provided to the lock comparator from the test controller.

Example 15. The system of one of examples 10 to 14, where the test logic circuit further includes a fast cycles comparator, the fast cycles comparator being configured to perform a comparison between a measured number of fast clock cycles from the fast cycles counter and an expected number of fast clock cycles.

Example 16. The system of example 15, where the fast cycles comparator is further configured to perform the comparison between the measured number of fast clock cycles from the fast cycles counter and the expected number of fast clock cycles using a range extending above and below the expected number of fast clock cycles by a fast cycle range.

Example 17. The system of example 16, where the expected number of fast clock cycles and the fast cycle range are provided to the fast cycles comparator from the test controller.

Example 18. A method for testing a circuit, the method including: enabling a test logic circuit with a test controller, the test logic circuit being coupled to a phase-locked loop and to the test controller; counting a number of clock cycles of the phase-locked loop with the test logic circuit using a reference clock as a reference, the reference clock being coupled to the test logic circuit; and determining a clock frequency of the phase-locked loop with the test controller using the counted number of clock cycles.

Example 19. The method of example 18, further including counting a number of cycles of the reference clock between an activation time of the phase-locked loop and a locked state time of the phase-locked loop with the test logic circuit.

Example 20. The method of one of examples 18 or 19, where determining the clock frequency of the phase-locked loop with the test controller occurs during runtime of an application, the application being run on a device including the test logic circuit, the test controller, and the phase-locked loop.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A system for testing a circuit, the system comprising:
- a phase-locked loop (200);
- a test logic circuit (400, 500, 600, 700), the test logic circuit (400, 500, 600, 700) being coupled to the phase-locked loop (200), the test logic circuit (400, 500, 600, 700) being configured (480) to count a number of clock cycles of the phase-locked loop (200) using a reference clock (414) as a reference, the reference clock (414) being coupled to the test logic circuit (400, 500, 600, 700); and
- a test controller (300), the test controller (300) being coupled to the phase-locked loop (200) and to the test logic circuit (400, 500, 600, 700), the test controller (300) being configured to measure a clock frequency of the phase-locked loop with the counted number (420) of clock cycles received from the test logic circuit (400, 500, 600, 700).

2. The system of claim 1, wherein the test logic circuit (400, 500, 600, 700) is further configured (450) to count a number of cycles of the reference clock (414) between an activation time of the phase-locked loop (200) and a locked state time of the phase-locked loop (200).

3. The system of claim 2, wherein the test logic circuit (400, 500, 600, 700) is further configured to provide a lock status signal (424) to the test controller (300) based on the counted number of cycles of the reference clock (414) between the activation time of the phase-locked loop (200) and the locked state time of the phase-locked loop (200).

4. The system of any of the previous claims, wherein the test logic circuit (400, 500, 600, 700) comprises a reference cycles counter (470), the reference cycles counter (470) being configured to set a window over which the number of clock cycles of the phase-locked loop are counted.

5. The system of claim 4, wherein the test logic circuit (400, 500, 600, 700) further comprises a delay reference counter (460), the delay reference counter (460) being configured to enable the reference cycles counter (470) after a delay time.

6. The system of any of the previous claims, wherein the test logic circuit (400, 500, 600, 700) comprises a clock gating cell (440), the clock gating cell being configured to gate a clock signal (406) from the phase-locked loop (200).

7. The system of any of the previous claims, wherein the test controller (300) is controlled using an advanced peripheral bus interface, the advanced peripheral bus interface being coupled to the test controller through a bridge.

8. The system of any of the previous claims, wherein the test controller (300) is further configured to use an IEEE 1149.1, IEEE 1149.x, IEEE 1500, or IEEE 1687 interface.

9. The system of any of the previous claims, wherein the test controller is further configured to run a built-in self test.

10. The system of any of the previous claims, wherein the test logic circuit (400, 500, 600, 700) comprises:
- a lock cycles counter (450), the lock cycles counter (450) being configured to count a number of cycles of a reference clock (414) between an activation time of the phase-locked loop (200) and a locked state time of the phase-locked loop (200); and
- a fast cycles counter (480), the fast cycles counter (480) being configured to count a number of fast clock cycles of the phase-locked loop (200) using the reference clock (414) as a reference.

11. The system of claim 10, wherein the test logic circuit (400, 500, 600, 700) further comprises a lock comparator (650), the lock comparator (650) being configured to perform a comparison between a measured number of lock cycles from the lock cycles counter (450) and an expected maximum number of lock cycles, wherein the expected maximum number of lock cycles is preferably provided (602) to the lock comparator (650) from the test controller (300).

12. The system of claim 10 or claim 11, wherein the test logic circuit (400, 500, 600, 700) further comprises a fast cycles comparator (580), the fast cycles comparator (580) being configured to perform a comparison between a measured number of fast clock cycles from the fast cycles counter (480) and an expected number of fast clock cycles.

13. The system of claim 12, wherein the fast cycles comparator (580) is further configured to perform the comparison between the measured number of fast clock cycles from the fast cycles counter (480) and the expected number of fast clock cycles using a range extending above and below the expected number of fast clock cycles by a fast cycle range, wherein the expected number of fast clock cycles and the fast cycle range are preferably provided (502, 504) to the fast cycles comparator from the test controller (300).

14. A method for testing a circuit via a system according to any of the previous claims, the method comprising:
- enabling (802) the test logic circuit (400, 500, 600, 700) with the test controller (300), the test logic circuit (300) being coupled to the phase-locked loop (200) and to the test controller (300);
- counting (804) a number of clock cycles of the phase-locked loop (200) with the test logic circuit (400, 500, 600, 700) using a reference clock (414) as a reference, the reference clock (414) being coupled to the test logic circuit (400, 500, 600, 700); and
- determining (806) a clock frequency of the phase-locked loop with the test controller (300) using the counted number of clock cycles.

15. The method of claim 14, wherein determining the clock frequency of the phase-locked loop (200) with the test controller (300) occurs during runtime of an application, the application being run on a device including the test logic circuit (400, 500, 600, 700), the test controller (300), and the phase-locked loop (200).
